Europäisches Patentamt

European Patent Office

Office européen des brevets

(11) Veröffentlichungsnummer: **0 301 358**

**A1**

(12) **EUROPÄISCHE PATENTANMELDUNG**

(21) Anmeldenummer: 88111543.0

(22) Anmeldetag: 18.07.88

(51) Int. Cl.4: **G01R 31/34**

(30) Priorität: 31.07.87 DE 3725534

(43) Veröffentlichungstag der Anmeldung:
01.02.89 Patentblatt 89/05

(84) Benannte Vertragsstaaten:
CH DE FR LI SE

(71) Anmelder: **Siemens Aktiengesellschaft Berlin
und München**
**Wittelsbacherplatz 2**
**D-8000 München 2(DE)**

(72) Erfinder: **Gretsch, Ralf, Prof.**
**Kleefeld 14**
**D-8520 Erlangen(DE)**

(54) **Verfahren zur Wicklungswiderstandsmessung einer stromrichtergespeisten Wechsel- oder Drehstrommaschine während des Betriebes.**

(57) Die Erfindung bezieht sich auf ein Verfahren zur Wicklungswiderstandsmessung einer stromrichtergespeisten Wechsel- oder Drehstrommaschine (8) während des Betriebes mittels eines Meßgleichstromes $(i_{-U})$ und einer Schaltungsanordnung zur Durchführung des Verfahrens. Erfindungsgemäß wird zur Erzeugung von Meßgleichströmen $(i_{-U}, i_{-V}, i_{-W})$ in den Phasenströmen $(i_U, i_V, i_W)$ der Zündzeitpunkt wenigstens eines aufkommutierenden Ventils (T6) des Stromrichters (6) um einen vorbestimmten veränderbaren Verstellwinkel $(\Delta\alpha)$ verzögert, wodurch die Stromführungszeit dieses aufkommutierenden Ventils (T6) verkürzt und die Stromführungszeit eines mit dem verzögert aufkommutierenden Ventil (T6) abkommutierenden Ventils (T4) verlängert werden, werden aus dem gemessenen Maschinenstrom $(i_U)$ der erzeugte Meßgleichstrom $(i_{-U})$ und aus einer gemessenen Klemmenspannung $(u_U'v')$ der Wechsel- oder Drehstrommaschine (8) die erzeugte verkettete Meßgleichspannung $(u_{-UV})$ herausgefiltert und wird aus der verketteten Meßgleichspannung $(u_{-UV})$ und dem Meßgleichstrom $(i_{-U})$ mittels einer Quotientenbildung der Wicklungswiderstand (R) ermittelt. Somit kann man bei einer stromrichtergespeisten Drehstrommaschine (8) während des Betriebes einen Wicklungswiderstand (R) messen, ohne dabei eine nichtlineare Widerstandsschaltung in einem Verbindungsleiter (U) zu verwenden.

FIG 2

EP 0 301 358 A1

**Verfahren zur Wicklungswiderstandsmessung einer stromrichtergespeisten Wechsel- oder Drehstrommaschine während des Betriebes**

Die Erfindung bezieht sich auf ein Verfahren zur Wicklungswiderstandsmessung einer stromrichtergespeisten Wechsel- oder Drehstrommaschine während des Betriebes mittels eines als Gleichanteil des Phasenstromes vorhandenen Meßgleichstromes und auf eine Schaltungsanordnung zur Durchführung des Verfahrens.

Aus der DE-PS 32 28 815 ist eine Schaltungsanordnung mit einer Meßgleichspannungsquelle für eine von netzfrequenten Betriebsströmen gespeiste Wicklung bekannt. Mindestens in einem der Verbindungsleiter zwischen Netz und Wicklung einer Wechsel-oder Drehstrommaschine ist als Meßgleichspannungsquelle eine nur für die Meßdauer wirksame nichtlineare Widerstandsschaltung angeordnet. Der Widerstandswert dieser nichtlinearen Widerstandsschaltung ändert sich stark in Abhängigkeit von der Polarität des sie durchfließenden netzfrequenten Betriebsstromes. Die so entstehende Gleichspannungskomponente ist als Meßgleichspannung außer der Wicklung einem nur die Gleichspannung erfassenden Meßglied zugeführt. Als nichtlineare Widerstandsschaltung ist beispielsweise ein niederohmiger einstellbarer Widerstand mit paralleler Diode und ein Überbrückungsschalter für die Parallelanordnung aus Widerstand und Diode vorgesehen. Bei dieser Schaltungsanordnung muß die nichtlineare Widerstandsschaltung für den vollen Betriebsstrom ausgelegt sein. Ferner verursacht die nichtlineare Widerstandsschaltung während der Messung Zusatzverluste.

Der Erfindung liegt nun die Aufgabe zugrunde, ein Verfahren zur Wicklungswiderstandsmessung einer stromrichtergespeisten Wechsel- oder Drehstrommaschine während des Betriebes mittels eines Meßgleichstromes und eine Schaltungsanordnung zur Durchführung des Verfahrens anzugeben, wobei auf eine nichtlineare Widerstandsschaltung verzichtet werden kann.

Diese Aufgabe wird erfindungsgemäß dadurch gelöst, daß zur Erzeugung von Meßgleichströmen in den Phasenströmen der Zündzeitpunkt wenigstens eines aufkommutierenden Ventils des Stromrichters um einen vorbestimmten veränderbaren Verstellwinkel verzögert wird, wodurch die Stromführungszeit dieses aufkommutierenden Ventils verkürzt und die Stromführungszeit eines mit dem verzögert aufkommutierenden Ventil abkommutierenden Ventils verlängert werden, daß aus dem gemessenen Maschinenstrom der erzeugte Meßgleichstrom und aus einer gemessenen Klemmenspannung der Wechsel- oder Drehstrommaschine die erzeugte verkettete Meßgleichspannung herausgefiltert werden, wobei die gemessene Klemmenspannung aus den Phasenspannungen besteht, die jeweils durch die verzögert kommutierenden Ventile einen Gleichanteil enthalten, und daß aus der verketteten Meßgleichspannung und dem Meßgleichstrom mittels einer Quotientenbildung der Wicklungswiderstand ermittelt wird.

Bei diesem Verfahren werden die Zündzeitpunkte des zur Motorspeisung benötigten Umrichters zur Messung des Wicklungswiderstandes während des Betriebes in geeigneter Weise unsymmetrisch verstellt, so daß sich bei symmetrischer Maschinenwicklung ein Gleichanteil im Maschinenstrom einstellt. Dieser als Meßgleichstrom erzeugte Gleichanteil im Maschinenstrom kann nun mit einfachen bekannten Mitteln ausgewertet werden. Da aus der DE-PS 32 28 815 bekannt ist, daß nur eine geringe relative Gleichspannung von etwa 0,1 bis 1 % der Nennspannung der Drehstrommaschine zur Messung benötigt wird, genügt eine Verschiebung wenigstens eines Zündzeitpunktes um einen Verstellwinkel von 0,2 bis 2° el, vorausgesetzt im Zwischenkreis des Umrichters steht die volle Zwischenkreisspannung zur Verfügung. Bei reduzierter Spannung, z.B. bei geringer Drehzahl der Maschine, vergrößert sich der benötigte Verstellwinkel entsprechend. Somit kann man mit diesem Verfahren den Wicklungswiderstandswert einer Wicklung einer stromrichtergespeisten Wechsel- oder Drehstrommaschine während des Betriebes messen, ohne dabei eine nichtlineare Widerstandsschaltung zu verwenden. Außerdem vermindern sich die Verluste während der Messung, vor allem aber der zur Messung notwendige Schaltungsaufwand, erheblich.

Bei einem vorteilhaften Verfahrensschritt wird der veränderbare Verstellwinkel so gesteuert, daß einem aus dem gemessenen Maschinenstrom gebildeten effektiven Strom laufend ein zugehöriger Verstellwinkel zugeordnet wird, wobei der Meßgleichstrom konstant bleibt.

Bei Stromrichter-Antrieben ist mit häufigen Wechseln beim Drehmoment und bei der Drehzahl zu rechnen. Dadurch entstehen bei konstant eingestellten Verstellwinkel auch Schwankungen in der erzeugten Meßgleichgleichspannung bzw. dem erzeugten Meßgleichstrom, wodurch Fehler bei der Wicklungswiderstandsbestimmung sich ergeben. Durch den vorteilhaften Verfahrensschritt, d.h. durch die Steuerung des Verstellwinkels im offenen Kreis können diese Fehler vermieden werden. Es besteht nämlich bei konstanter Verzögerungszeit ein praktisch linearer Zusammenhang zwischen dem von der Belastung abhängigen effektiven Maschinenstrom und dem sich einstellenden Meßgleichstrom. Die Verstellwinkel variieren mit den Parametern der Umrichter-Maschinen-Kombination und können dementsprechend berechnet werden.

In einem weiteren vorteilhaften Verfahrensschritt wird der veränderbare Verstellwinkel so gesteuert, daß der effektive Strom umgekehrt proportional zum Verstellwinkel ist. Somit ergibt sich für den Verstellwinkel in Abhängigkeit des jeweiligen effektiven Maschinenstroms eine Hyperbelfunktion, da im einfachsten Fall die Abhängigkeit der Verstellwinkel von den Parametern der Umrichter-Maschinen-Kombination der Meßgleichstrom sowohl zum effektiven Strom wie auch zum Verstellwinkel proportional ist.

Bei einer vorteilhaften Schaltungsanordnung zur Durchführung des Verfahrens ist in einem Steuersatz wenigstens eine Verschiebeanordnung vorgesehen, die das Zündzeitpunkt-Signal wenigstens eines Ventils des Stromrichters zeitlich verschiebt, ist wenigstens ein Shunt-Widerstand in einem Verbindungsleiter zwischen dem Stromrichter und der Wechsel- oder Drehstrommaschine überbrückbar angeordnet, wobei seine Widerstandsklemmen über einen ersten Tiefpaß mit einem ersten Eingang eines Quotientenbildners verknüpft sind und ist ein zweiter Eingang des Quotientenbildners über einen zweiten Tiefpaß mit seinen zwei Klemmen der stromrichtergespeisten Wechsel- oder Drehstrommaschine verbunden.

Bei dieser Schaltungsanordnung wird zunächst der zur Wicklungswiderstandsmessung notwendige Meßgleichstrom erzeugt, indem im Steuersatz wenigstens ein Zündzeitpunkt-Signal wenigstens eines Ventils des Stromrichters mittels einer Verschiebeanordnung zeitlich verschoben wird. Diese Verzögerung wenigstens eines Zündzeitpunktes eines Ventils ist nicht beschränkt auf eine 120°-Steuerung des Stromrichters, sondern kann auch bei einer 180°-Steuerung des Stromrichters vorgenommen werden. Der so entstandene Meßgleichstrom und die Meßgleichspannungsanteile zweier Phasenspannungen werden einer Verarbeitungsschaltung zugeführt, die daraus den gemessenen Wicklungswiderstandswert ermittelt. Somit erhält man eine Schaltungsanordnung, mit der man während des Betriebes einen Wicklungswiderstandswert einer Wicklung einer Wechsel- oder Drehstrommaschine messen kann, ohne dabei einen nichtlinearen Widerstand in einem Verbindungsleiter zwischen Netz und Wicklung der Maschine zu verwenden. Auch die Verlustleistung während des Messens verringert sich erheblich.

In einer weiteren vorteilhaften Schaltungsanordnung sind die Widerstandsklemmen des Shunt-Widerstandes mit einem Effektivwertumsetzer verknüpft, dessen Ausgang mit einem Kennliniengeber verbunden ist, und ist der Ausgang des Kennliniengebers mit den Voreinstellungseingängen des ersten programmierbaren Rückwärtszählers der Verschiebeanordnung verknüpft.

Mit Hilfe dieser Schaltungsanordnung kann man Schwankungen in der Meßgleichspannung bzw. dem Meßgleichstrom infolge von häufigen Wechseln bei Drehmoment und Drehzahl der stromrichtergespeisten Wechsel- oder Drehstrommaschine ausregeln. Da bei konstanter Verzögerungszeit eines Ventils ein linearer Zusammenhang zwischen dem von der Belastung abhängigen effektiven Maschinenstrom und dem sich einstellenden Meßgleichstrom besteht, kann man den verstellbaren Verstellwinkel auf diese einfache Weise steuern. D.h. im Kennlinien- oder Kennfeldgeber sind zu jedem Effektiwert des Maschinenstroms ein zugehöriger Verstellwinkel eines Ventils des Stromrichters hinterlegt, so daß der Meßgleichstrom konstant bleibt. Im einfachsten Fall ist als Kennlinie im Kennfeldgeber eine Hyperbelfunktion hinterlegt, d.h. der veränderbare Verstellwinkel ist umgekehrt proportional zum Effektivwert des Maschinenstroms.

Zur weiteren Erläuterung der Erfindung wird auf die Zeichnung Bezug genommen, in der Ausführungsbeispiele nach der Erfindung schematisch veranschaulicht sind.

FIG 1 zeigt eine Schaltungsanordnung eines stromrichtergespeisten Antriebes, in,

FIG 2 ist ein Blockschaltbild der Schaltungsanordnung zur Durchführung des erfindungsgemäßen Verfahrens dargestellt.,

FIG 3 zeigt eine Verschiebeanordnung des Steuersatzes nach, FIG 2, die,

FIG 4 bis 6 veranschaulichen die Wirkungsweise eines verzögert gezündeten Ventils bei einer 120°-Steuerung des Stromrichters des stromrichtergespeisten Antriebes, die,

FIG 7 bis 9 zeigen die Wirkungsweise eines verzögert gezündeten Ventils bei einer 180°-Steuerung des Stromrichters des stromrichtergespeisten Antriebes und in,

FIG 10 ist eine weitere Ausführungsform des Blockschaltbildes der Schaltungsanordnung zur Durchführung des erfindungsgemäßen Verfahrens nach FIG 2 dargestellt.

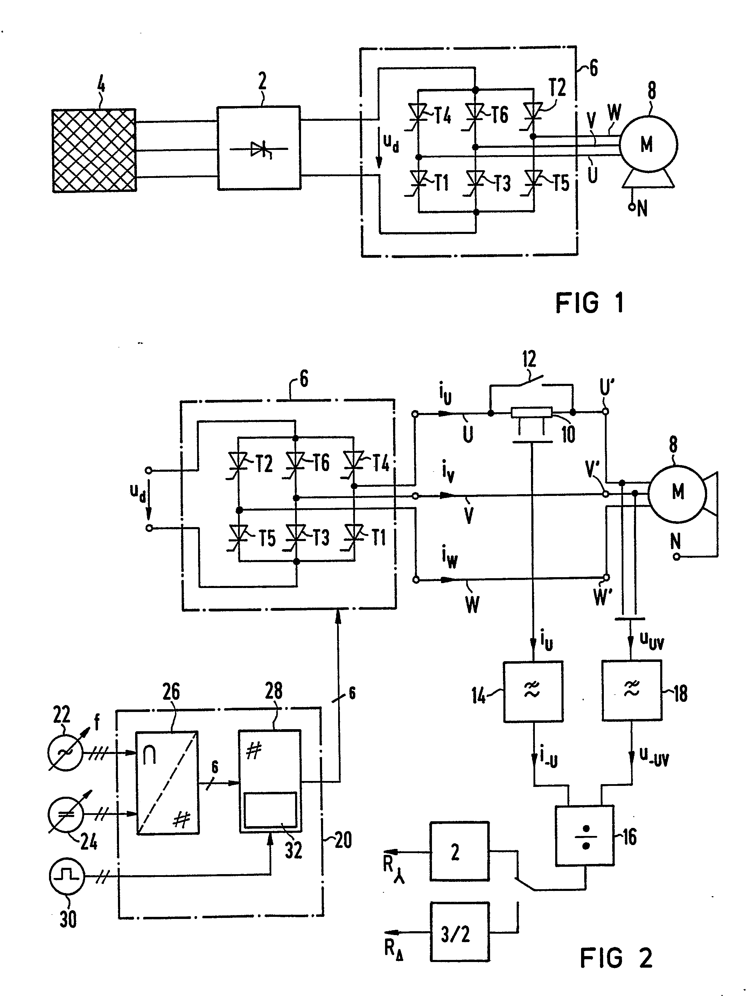

In FIG 1 ist eine Schaltungsanordnung eines stromrichtergespeisten Antriebes dargestellt. Ein netzseitiger Stromrichter 2 wandelt eine mit einem Netz 4 bei einer Netzfrequenz $f_N$ = 50 bzw. 60 Hz ausgetauschte Drehstromleistung in eine Gleichspannung $u_d$ bzw. in einem Gleichstrom einstellbarer Größe um. Der maschinenseitige Stromrichter 6 erzeugt daraus wieder eine mit einer Wechsel- oder Drehstrommaschine 8 ausgetauschte Wechsel- oder Drehstromleistung variabler Frequenz $f_M$ = 0 bis $f_{max}$. Als maschinenseitiger Stromrichter 6 ist eine dreiphasige Brückenschaltung mit den Thyristoren T1 bis T6 vorgesehen. Die drei Brückenzweige sind mittels Verbindungsleiter U, V und W, auch Phasenleiter genannt, mit der Wechsel- oder Drehstrommaschine 8 verbunden. Aus Übersichtlichkeitsgründen sind die Steuerungen des netzseitigen Stromrichters 2 und des maschinenseitigen Stromrichters 6 nicht dargestellt worden.

In FIG 2 ist ein Blockschaltbild der Schaltungsanordnung zur Durchführung des erfindungsgemäßen

EP 0 301 358 A1

Verfahrens dargestellt. Aus Übersichtlichkeitsgründen sind das Netz 4 und der netzseitige Stromrichter 2 nicht dargestellt. Dem maschinenseitigen Stromrichter 6 ist eingangsseitig die Zwischenkreisspannung $u_d$ zugeführt und ausgangsseitig ist der Stromrichter 6 mittels der Verbindungsleiter U, V und W mit den Eingangsklemmen U', V' und W' der Wechsel- oder Drehstrommaschine 8 verknüpft. Im Verbindungsleiter U ist ein Shunt-Widerstand 10 angeordnet, der mittels eines Schalters 12 überbrückbar ist. Die Klemmen des Shunt-Widerstandes 10 sind mit einem ersten Tiefpaß 14 verknüpft, dessen Ausgang mit einem ersten Eingang eines Quotientenbildners 16 verbunden ist. Die Eingangsklemmen U' und V' der Wechsel- oder Drehstrommaschine 8 sind einem zweiten Tiefpaß 18 zugeführt. Der Ausgang dieses zweiten Tiefpasses 18 ist mit einem zweiten Eingang des Quotientenbildners 16 verknüpft. Der Stromrichter 6 erhält von einem Steuersatz 20 die Zündimpulse, wobei jeder Zündimpuls aus einer Impulskette besteht. Diesem Steuersatz 20 wird die gewünschte Frequenz des Maschinen-Drehfeldes über einen Drehspannungsgenerator 22 vorgegeben, dessen Spannungen nicht notwendigerweise sinusförmig sein müssen. Außerdem ist der Steuersatz 20 mit einem Steuer-Gleichspannungsgenerator 24 verknüpft, dessen Steuer-Gleichspannung die Zündverzögerungen gegenüber den Nulldurchgängen des vorgegebenen Drehspannungs-Systems bestimmt. Im Umsetzerblock 26 werden aus den analogen Drehspannungen und der Steuer-Gleichspannung die Zündzeitpunkte für die Ventile T1 bis T6 festgelegt, die am Ausgang des Umsetzerblockes 26 digital anstehen. Diese digitalen Zündzeitpunkte sind einem Impulsformer 28 zugeführt, der an das jeweilige Ventil T1 bis T6 des Stromrichters 6 eine Kette von Zündimpulsen abgibt, deren Folgefrequenz durch einen Taktgenerator 30 bestimmt wird. Außerdem enthält der Impulsformer 28 des Steuersatzes 20 eine Verschiebeanordnung 32, die einen Zündzeitpunkt eines Ventils T1 bis T6 des Stromrichters 6 zeitlich verschiebt. Wenn man alle Zündzeitpunkte der Ventile T1 bis T6 des Stromrichters 6 zeitlich verschieben wollte, so benötigt man soviele Verschiebeanordnungen 32 wie an Ventilen im Stromrichter 6 vorhanden sind.

Die Strommessung erfolgt über den Shunt-Widerstand 10, der nur während der Messung benötigt wird. Dieser gemessene Maschinenstrom $i_U$ enthält einen Gleichanteil $i_{-U}$, der auch als Meßgleichstrom $i_{-U}$ bezeichnet wird. Mittels des Tiefpasses 14 wird der Meßgleichstrom $i_{-U}$ aus dem gemessenen Maschinenstrom $i_U$ herausgefiltert und dem Quotientenbildner 16 zugeführt. Die verkettete Spannung $u_{UV}$, der auch ein Gleichanteil, nämlich eine Meßgleichspannung $u_{-UV}$, überlagert ist, kann direkt an den Maschinenklemmen U' und V' gemessen und zum Tiefpaß 18 geführt werden. Dieser Tiefpaß 18 filtert die Meßgleichspannung $u_{-UV}$ aus der verketteten Spannung $u_{UV}$ heraus und führt sie dem Quotientenbildner 16 zu.

Bei einer symmetrischen Wicklung der Wechsel- oder Drehstrommaschine 8 ist der Gleichanteil im über die Klemme W' fließenden Maschinenstrom $i_{-W} = 0$, wenn die durch einen Verstellwinkel verzögert gezündetes Ventil T6 entstandenen Spannungs-Zeitflächen der Phasenspannung $u_U$ und $u_V$ entgegengesetzt gleich sind. Damit ergibt sich mit den Gleichanteilen $i_{-U} = -i_{-V}$, der Widerstandswert einer Wicklung im Falle einer Sternschaltung der Wicklung der Maschine zu $R_\lambda = u_{-U}'N/i_{-U}$ bzw. $R_\lambda = 2 u_{-U}'V'/i_{-U}$, wobei die Spannung $u_{-UN}$ die Phasenspannung und die Klemme N der Sternpunkt der Wechsel- oder Drehstrommaschine 8 ist. Wenn die Wicklungen des Wechsel- oder Drehstrommotors 8 in einem Dreieck geschaltet sind, so ergibt sich der Widerstandswert einer Wicklung zu $R_\Delta = 3/2 \cdot u_{-U}'V'/i_{-U}$.

Bei einer unsymmetrischen in Dreieck geschalteten Wicklung einer Drehstrommaschine 8 wird ein Verstellwinkel $\Delta\alpha$ an dem Ventil T2 bzw. T5 so eingestellt, daß $u_{-UV} = u_{-UW}$, damit am Widerstand $R_{VW}$ der Spannungsabfall $u_{-VW} = 0$ wird. Durch die Messung der entsprechenden Meßgleichströme $i_{-V}$ und $i_{-W}$ ergeben sich die Stromwiderstände $R_{UV} = u_{-UV}/i_{-V}$ und $R_U = u_{-UW}/i_{-W}$. Bei einer unsymmetrischen in Stern geschalteten Wicklung einer Drehstrommaschine 8 genügt es, die Sternspannungen $u_{UN}$, $u_{VN}$ und $u_{WN}$ und die Phasenströme $i_U$, $i_V$ und $i_W$ zu messen und die zum selben Phasenleiter gehörenden Werte durcheinander zu dividieren. Sinngemäß ist bei der Bestimmung des Widerstandes $R_{VW}$ vorzugehen.

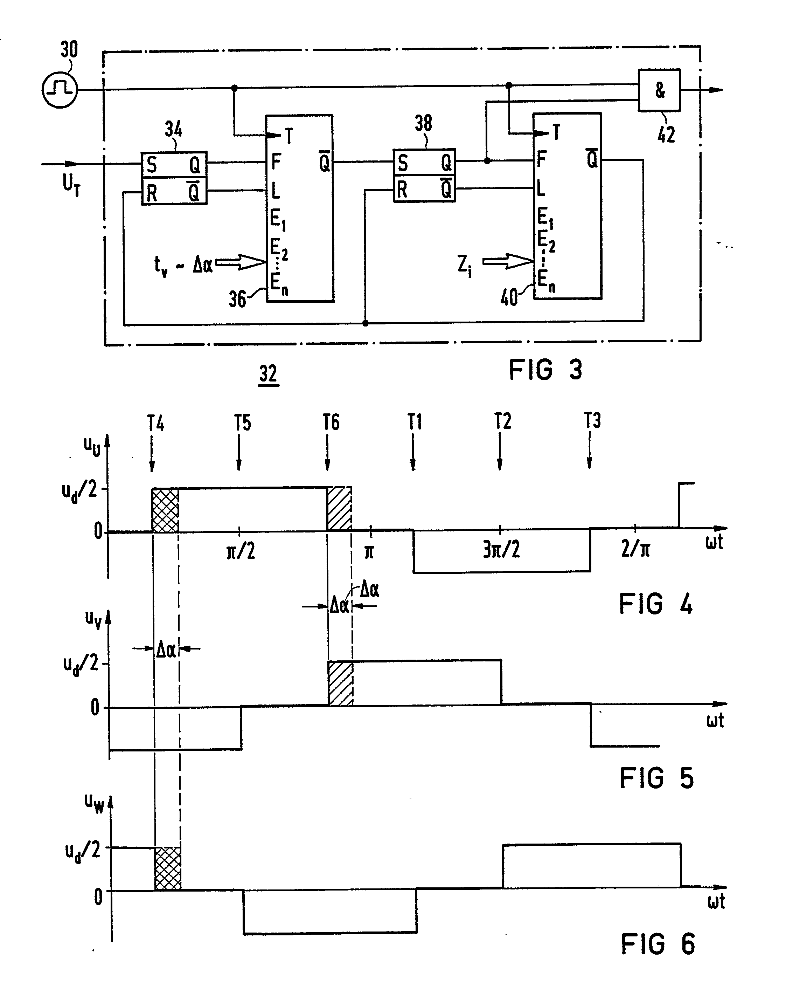

Die FIG 3 zeigt eine Ausführungsform der Verschiebeanordnung 32 des Impulsformers 28 des Steuersatzes 20. Ein unverzögertes Zündzeitpunkt-Signal $U_T$ des Umsetzerblocks 26 ist einem Set-Eingang S eines ersten RS-Flip-Flops 34 zugeführt, dessen nichtinvertierender Ausgang Q mit einem Freigabeeingang F des ersten Rückwärtszählers 36 verknüpft ist. Der invertierende Ausgang $\overline{Q}$ des RS-Flip-Flops 34 ist mit einem Eingang L des ersten Rückwärtszählers 36 verbunden, wodurch die Voreinstellung des ersten Rückwärtszählers 36 freigegeben wird, d.h. der Rückwärtszähler 36 wird auf einen voreingestellten Zählerstand gesetzt. Ein Takteingang T des ersten Rückwärtszählers 36 ist mit dem Taktgenerator 30 verbunden. Ein invertierender Ausgang $\overline{Q}$ des ersten Rückwärtszählers 36 ist mit einem Set-Eingang S eines zweiten RS-Flip-Flops 38 verknüpft, dessen nichtinvertierender Ausgang Q einerseits mit einem Freigabeeingang F eines zweiten Rückwärtszählers 40 und andererseits mit einem Eingang eines UND-Gatters 42 verbunden ist. Ein invertierender Ausgang $\overline{Q}$ des zweiten RS-Flip-Flops 38 ist mit einem Eingang L des zweiten Rückwärtszählers 40 verbunden, wodurch ein voreingestellter Zählerwert aktiviert wird. Ein

4

nichtinvertierender Ausgang $\overline{Q}$ des zweiten Rückwärtszählers 40 ist jeweils mit einem Reset-Eingang R des ersten bzw. zweiten RS-Flip-Flops 34 bzw. 38 verknüpft. Der Taktgenerator 30 ist ebenfalls mit dem Takteingang T des zweiten Rückwärtszählers 40 und mit einem zweiten Eingang des UND-Gatters 42 verbunden. Als Rückwärtszähler 36 und 40 sind einstellbare Rückwärtszähler vorgesehen, wobei über Einstelleingänge $E_l$ bis $E_n$ beliebige Zahlen eingestellt werden können. Am ersten Rückwärtszähler 36 wird an den Einstelleingängen $E_l$ bis $E_n$ der Verstellwinkel $\Delta\alpha$ oder eine diesen Verstellwinkel $\Delta\alpha$ entsprechende Verzögerungszeit $t_v$ als Vielfaches der vom Taktgenerator 30 gelieferten Taktfrequenz eingestellt. Am zweiten Rückwärtszähler 40 wird die Anzahl der Impulse der Zündimpulskette $Z_i$ eingestellt.

Bei Eintreffen eines zunächst unverzögerten Zündzeitpunkt-Signals $U_T$ aus dem Umsetzerblock 26 wird der Ausgang Q des ersten RS-Flip-Flops 34 auf "high" gesetzt und dadurch der erste Rückwärtszähler 36 freigegeben. Dadurch zählt dieser Rückwärtszähler 36 mit der Taktfrequenz des Taktgenerators 30 vom voreingestellten Wert aus rückwärts bis zum Wert Null zurück. Mit dem Erreichen des Zählerstandes Null des ersten Rückwärtszählers 30 wird das zweite RS-Flip-Flop 38 gesetzt, das seinerseits den zweiten Rückwärtszähler 40 freigibt. Von der voreingestellten Zahl der gewünschten Impulse in der Impulskette aus zählt dieser ebenfalls mit der Taktfrequenz rückwärts. Gleichzeitig werden am Ausgang des UND-Gatters 42 die Impulse der Zündimpulskette bereitgestellt, wobei der Zündzeitpunkt dieser Zündimpulskette um einen vorbestimmten Verstellwinkel $\Delta\alpha$ verschoben ist. Wenn der zweite Rückwärtszähler 40 den Zählerstand Null erreicht hat, setzt dieser Rückwärtszähler 40 die beiden RS-Flip-Flops 34 und 38 zurück, d.h. die Ausgänge Q der RS-Flip-Flops 34 und 38 werden auf "low" gesetzt, wogegen die Ausgänge $\overline{Q}$ der RS-Flip-Flops 34 und 38 auf "high" gesetzt werden. Durch diese Low-Signale am Ausgang Q der RS-Flip-Flops 34 und 38 werden die beiden Rückwärtszähler 36 und 40 und das UND-Gatter 42 gesperrt. Durch das High-Signal an den Ausgängen $\overline{Q}$ der RS-Flip-Flops 34 und 38 wird jeweils die Voreinstellung der beiden Rückwärtszähler 36 und 40 freigegeben, wodurch die Zähler 36 und 40 jeweils in den vorbestimmten Zählerstand gelangen. Dadurch ist diese Verschiebeanordnung 32 für den nächsten Zyklus bereit.

In den FIG 4 bis 6 ist die Wirkungsweise eines verzögert gezündeten Ventils T6 des Stromrichters 6 bei einer 120°-Steuerung des Stromrichters 6 dargestellt. In FIG 4 ist die Phasenspannung $u_U$ in einem Diagramm über der Periode $2\pi$ aufgetragen. Diese Phasenspannung $u_U$ ist am Ausgang des Stromrichters 6 abnehmbar bei einer Amplitude $u_d$ der Zwischenkreisspannung am Eingang des Stromrichters 6. Außerdem sind durch die Pfeile T1 bis T6 die Zündzeitpunkte der Ventile T1 bis T6 des Stromrichters 6 angezeigt. In der FIG 5 bzw. 6 ist die Phasenspannung $u_V$ bzw. $u_W$ in einem Diagramm über der Periode $2\pi$ aufgetragen. Alle drei Phasenspannungen $u_U$, $u_V$ und $u_W$ bilden zusammen ein Drehstromsystem. Wenn der Zündzeitpunkt des aufkommutierenden Ventils T6 um einen Verstellwinkel $\Delta\alpha$ verschoben wird, so wirkt sich die verspätete Zündung des Ventils T6 im Brückenzweig V auf die Phasenspannungen $u_U$ und $u_V$ aus. Durch das verzögerte Aufkommutieren des Ventils T6 im Brückenzweig V kommutiert das Ventil T4 im Brückenzweig U verzögert ab. Diese Verzögerung der Kommutierung zwischen den Phasen U und V um einen Winkel $\Delta\alpha$ wirkt sich positiv bzw. negativ auf die Phasenspannung $u_U$ bzw. $u_V$ aus. An der Maschinenklemme $U'$ tritt dadurch die in FIG 4 schraffierte Spannungszeitfläche positiv auf, wodurch die Stromführungszeit vergrößert wird und an der Maschinenklemme $V'$ trifft die Spannungszeitfläche gleichzeitig negativ auf, wodurch die Stromführungszeit verkürzt wird. Die an den Klemmen $U'$-N anliegende mittlere relative Gleichspannung ist dann $u_{\cdot UN}/\hat{u} = \Delta\alpha / 2\pi$ wobei N die Sternpunktklemme der Drehstrommaschine 8 ist, die an den Klemmen $V'$-N anliegende mittlere relative Gleichspannung $u_{\cdot UN}/\hat{u} = - \Delta\alpha / 2\pi$ und die an den Klemmen $U'$-$V'$ anliegende mittlere relative Gleichspannung, d.h. die anliegende relative verkettete Gleichspannung, $u_{\cdot UV} = \Delta\alpha/\pi$. Da nur eine geringe relative Gleichspannung von etwa 0,1 bis 1 % der Nennspannung der Wechsel- oder Drehstrommaschine 8 zur Wicklungswiderstandsmessung benötigt wird, genügt eine Verschiebung des Zündzeitpunktes eines aufkommutierenden Ventils um kleine Winkel $\Delta\alpha$ = 0,2 bis 2° el., wenn im Zwischenkreis die volle Zwischenkreisspannung $u_d$ zur Verfügung steht. Bei reduzierter Zwischenkreisspannung $u_d$, beispielsweise bei geringer Drehzahl der Maschine, vergrößert sich der benötigte Verstellwinkel entsprechend.

Außerdem kann neben dem verzögerten Zünden des Ventils T6 um einen Verstellwinkel $\Delta\alpha$ gleichzeitig auch ein anderes Ventil des Stromrichters 6 verzögert gezündet werden. In FIG 4 ist gezeigt, daß ebenfalls das Ventil T4 verspätet zündet. Dadurch kommutiert das Ventil T2 im Brückenzweig W verzögert ab. Diese Verzögerung der Kommutierung zwischen den Phasen U und W um einen Verstellwinkel $\Delta\alpha$ wirkt sich negativ bzw. positiv auf die Phasenspannung $u_U$ bzw. $u_W$ aus. Da der Verstellwinkel $\Delta\alpha$ des Ventils T6 gleich dem Verstellwinkel $\Delta\alpha$ des Ventils T4 ist, heben sich die Spannungszeitflächen der Phasenspannungen $u_U$ auf, wodurch kein Gleichanteil $u_{\cdot U}$ entsteht. Jedoch entsteht durch die verzögerte Zündung des Ventils T6 und T4 ein Gleichspannungsanteil $u_{\cdot V}$ und $u_{\cdot W}$. Um den verketteten Gleichanteil $u_{\cdot VW}$ zu erhalten, muß die Klemmenspannung $u_V'_W'$ der Wechsel- oder Drehstrommaschine 8 dem Tiefpaß 18 zugeführt werden. Außerdem muß der Phasenstrom $i_V$ oder $i_W$ dem Tiefpaß 14 zugeführt werden, die jeweils mittels eines Shunt-Widerstandes gemessen werden können. Somit kann man mehrere Ventile T1 bis T6 des Stromrichters 6 gleichzeitig verzögert zünden, um Meßgleichströme $i_U$, $i_V$ und $i_W$ zu erzeugen.

Statt der in den FIG 4 bis 6 gezeigten Verschiebung der Kommutierung des positiven Stromes von der Phase U auf die Phase V kann natürlich jede andere positive oder negative Kommutierung zur Erzeugung des Gleichanteils in Spannung und Strom benutzt werden. Ferner ist der gewünschte Effekt selbstverständlich mit einer Verschiebung $\Delta\alpha$ in voreilender oder nacheilender Richtung zu erzielen. In der nachfolgend angegebenen Tabelle ist die Auswirkung einer Zündzeitpunktverzögerung bei den Ventilen T1 bis T6 auf den Gleichanteil in den verschiedenen Strängen U, V und W der Maschine gezeigt, wenn eine 120°-Steuerung des Stromrichters zugrundegelegt wird.

| Zündverzögerung bei Ventil | Polarität der Gleichspannung | Wirkung auf Strang |
|---|---|---|
| T1 | pos. | U |
|    | neg. | W |
| T2 | pos. | V |
|    | neg. | W |
| T3 | pos. | V |
|    | neg. | U |
| T4 | pos. | W |
|    | neg. | U |
| T5 | pos. | W |
|    | neg. | V |
| T6 | pos. | U |
|    | neg. | V |

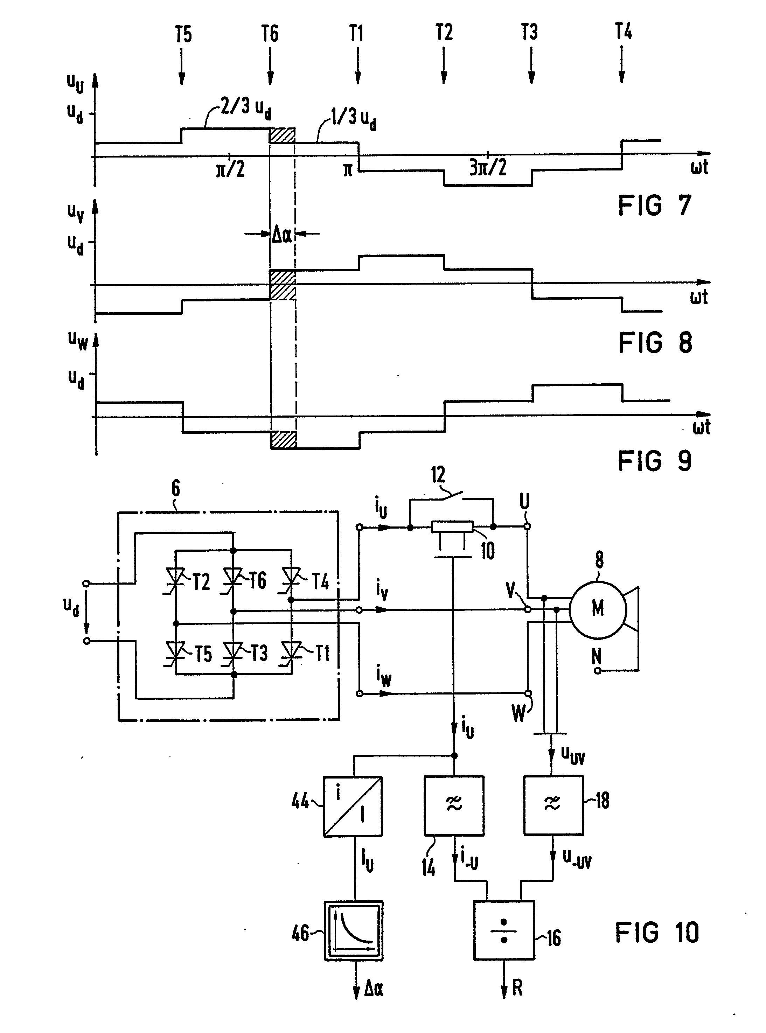

In den FIG 7 bis 9 ist die Wirkungsweise eines verzögert gezündeten Ventils T6 des Stromrichters 6 bei einer 180°-Steuerung des Stromrichters 6 dargestellt. In der FIG 7 bzw. 8 bzw. 9 ist die Phasenspannung $u_U$ bzw. $u_V$ bzw. $u_W$ in einem Diagramm über der Periode $2\pi$ aufgetragen. Auch hier zeigen die Pfeile T1 bis T6 die Zündzeitpunkte der Ventile T1 bis T6 des Stromrichters 6 bei einer 180°-Steuerung an. Wenn bei einer 180°-Steuerung ein Ventil T6 um einen Verstellwinkel $\Delta\alpha$ verzögert aufkommutiert wird, so werden in den drei Strängen U, V und W ein positiver bzw. negativer Gleichanteil hervorgerufen. Die Gleichanteile sind durch schraffierte Spannungszeitflächen dargestellt. D.h., wenn der Zündzeitpunkt des Ventils T6 um den Verstellwinkel $\Delta\alpha$ verschoben wird, so ist die mittlere relative Gleichspannung an der Maschinenklemme U' bzw. V' bzw. W' positiv bzw. negativ bzw. positiv. In der nachfolgend angegebenen Tabelle ist die Auswirkung einer Zündzeitpunkt-Verzögerung bei den Ventilen T1 bis T6 auf den Gleichanteil in den verschiedenen Strängen U, V und W der Maschine 8 gezeigt, wenn eine 180°-Steuerung des Stromrichters 6 zugrundegelegt wird.

| Zündverzögerung bei Ventil | Polarität der Gleichspannung | Wirkung auf Strang |
|---|---|---|
| T1 | pos. | U |
|  | neg. | V |
|  | neg. | W |
| T2 | pos. | U |
|  | pos. | V |
|  | neg. | W |
| T3 | neg. | U |
|  | pos. | V |
|  | neg. | W |
| T4 | neg. | U |
|  | pos. | V |
|  | pos. | W |
| T5 | neg. | U |
|  | neg. | V |
|  | pos. | W |
| T6 | pos. | U |
|  | neg. | V |
|  | pos. | W |

Die FIG 10 zeigt eine weitere Ausführungsform der Schaltungsanordnung nach FIG 2. In Stromrichter-Antrieben ist mit häufigem Wechsel von Drehmoment und Drehzahl zu rechnen. Dadurch entstehen bei konstant eingestelltem Verstellwinkel $\Delta\alpha$ auch Schwankungen in der Meßgleichspannung $u_{-UV}$ bzw. dem Meßgleichstrom $i_{-U}$. Dadurch ist auch der vermittelte bzw. gemessene Wicklungswiderstand einer Wicklung der Drehstrommaschine 8 mit einem Fehler behaftet. Daher wird eine Steuerung des Verstellwinkels $\Delta\alpha$ im offenen Kreis vorgesehen. Es besteht nämlich bei konstantem Verstellwinkel $\Delta\alpha$ ein praktisch linearer Zusammenhang zwischen dem von der Belastung abhängigen effektiven Maschinenstrom $I_U$ und dem sich einstellenden Meßgleichstrom $i_{-U}$. Der Maschinenstrom $i_U$, der mittels des Shunt-Widerstandes 10 gemessen wird, wird mittels eines Effektivwertumsetzers 44 in einen effektiven Maschinenstrom $I_U$ umgesetzt. Dieser effektive Maschinenstrom $I_U$ wird einem Kennlinien- oder Kennfeldgeber 46 zugeführt. Dieser Kennliniengeber 46 ordnet jedem effektiven Maschinenstrom $I_U$ derart einem Verstellwinkel $\Delta\alpha$ zu, daß der Meßgleichstrom $i_{-U}$ konstant bleibt. Im einfachsten Fall ist der Meßgleichstrom $i_{-U}$ sowohl zum effektiven Maschinenstrom $I_U$ wie auch zum Verstellwinkel $\Delta\alpha$ proportional, so daß gilt: $\Delta\alpha$ = const. $/I_{eff}$, d.h., es ergibt sich als Kennlinie eine Hyperbel. Als Kennliniengeber 46 kann ein programmierbarer Speicher vorgesehen sein, in dem die Kennlinie hinterlegt ist. Wenn der effektive Maschinenstrom $I_U$ bereits als digitaler Wert vorliegt, entspricht jeweils ein digitaler effektiver Maschinenstromwert $I_U$ dann einer Speicheradresse, deren Speicherinhalt einen Verstellwinkel $\Delta\alpha$ enthält. Diese Verstellwinkel $\Delta\alpha$ werden den Einstelleingängen $E_I$ bis $E_n$ des ersten Rückwärtszählers 36 zugeführt. Somit kann man auf einfache Weise selbst bei häufigem Wechsel bei Drehmoment und Drehzahl der Wechsel- oder Drehstrommaschine 8 fehlerfrei während des Betriebs den Wicklungswiderstand der Maschine 8 messen.

## Ansprüche

1. Verfahren zur Wicklungswiderstandsmessung einer stromrichtergespeisten Wechsel- oder Drehstrommaschine (8) während des Betriebes mittels eines als Gleichanteil des Phasenstromes ($i_U$) vorhandenen Meßgleichstromes ($i_{-U}$), **dadurch gekennzeichnet,** daß zur Erzeugung von Meßgleichströmen ($i_{-U}$, $i_{-V}$, $i_{-W}$) in den Phasenströmen ($i_U$, $i_V$, $i_W$) der Zündzeitpunkt wenigstens eines aufkommutierenden Ventils (T6) des Stromrichters (6) um einen vorbestimmten veränderbaren Verstellwinkel ($\Delta\alpha$) verzögert wird, wodurch die Stromführungszeit dieses aufkommutierenden Ventils (T6) verkürzt und die Stromführungszeit eines mit dem verzögert aufkommutierenden Ventil (T6) abkommutierenden Ventils (T4) verlängert werden, daß aus einem gemessenen Phasenstrom ($i_U$) der erzeugte Meßgleichstrom ($i_{-U}$) und aus einer gemessenen Klemmenspannung ($u_U{}'{}_V{}'$) der Wechsel-oder Drehstrommaschine (8) die erzeugte verkettete Meßgleichspannung ($u_{.UV}$) herausgefiltert werden, wobei die gemessene Klemmenspannung ($u_U'v'$) aus den Phasenspannungen ($u_U$, $u_V$) besteht, die jeweils durch die verzögert aufkommutierenden Ventile (T6, T4) einen Gleichanteil ($u_{.U}$, $u_{.V}$) enthalten, und daß aus der verketteten Meßgleichspannung ($u_{.UV}$) und dem Meßgleichstrom ($i_{.U}$) mittels einer Quotientenbildung der Wicklungswiderstand (R) ermittelt wird.

2. Verfahren zur Wicklungswiderstandsmessung nach Anspruch 1, **dadurchgekennzeichnet,** daß der veränderbare Verstellwinkel ($\Delta\alpha$) so gesteuert wird, daß einem aus dem gemessenen Maschinenstrom ($i_U$) gebildeten, effektiven Strom ($I_U$) laufend ein zugehöriger Verstellwinkel ($\Delta\alpha$) zugeordnet wird, wobei der Meßgleichstrom ($i_{.U}$) konstant bleibt.

3. Verfahren zur Wicklungswiderstandsmessung nach Anspruch 1, **dadurchgekennzeichnet,** daß der veränderbare Verstellwinkel ($\Delta\alpha$) so gesteuert wird, daß der effektive Strom ($I_U$) umgekehrt proportional zum Verstellwinkel ($\Delta\alpha$) ist.

4. Verfahren zur Wicklungswiderstandsmessung nach Anspruch 1, **dadurchgekennzeichnet** ,daß der veränderbare Verstellwinkel ($\Delta\alpha$) in Abhängigkeit von der Amplitude der Zwischenkreisspannung ($U_d$) gesteuert wird.

5. Schaltungsanordnung zur Durchführung des Verfahrens nach Anspruch 1, **dadurch gekennzeichnet,** daß in einem Steuersatz (20) wenigstens eine Verschiebeanordnung (32) vorgesehen ist, die den Zündzeitpunkt wenigstens eines Ventils (T6) des Stromrichters (6) zeitlich verschiebt, daß wenigstens ein Shunt-Widerstand (10) in einem Verbindungsleiter (U) zwischen dem Stromrichter (6) und der Wechsel- oder Drehstrommaschine (8) überbrückbar angeordnet ist, wobei seine Klemmen über einen ersten Tiefpaß (14) mit einem ersten Eingang eines Quotientenbildners (16) verknüpft sind, und daß ein zweiter Eingang des Quotientenbildners (16) über einen zweiten Tiefpaß (18) mit zwei Klemmen (U', V') der stromrichtergespeisten Wechsel- oder Drehstrommaschine (8) verbunden ist.

6. Schaltungsanordnung nach Anspruch 5, **dadurch gekennzeichnet,** daß die Verschiebeanordnung (32) aus zwei RS-Flip-Flops (34, 38), zwei Rückwärtszählern (36, 40) und einem UND-Gatter (42) besteht, wobei das unverzögerte Zündzeitpunkt-Signal einem Set-Eingang des ersten RS-Flip-Flops (34) zugeführt ist, dessen nichtinvertierender Ausgang (Q) mit einem Freigabeeingang (F) des ersten Rückwärtszählers (36) und ein invertierender Ausgang ($\overline{Q}$) des RS-Flip-Flops (34) mit einem Eingang (L) des ersten Rückwärtszählers (36), der die Voreinstellung des ersten Rückwärtszählers (36) freigibt, verknüpft sind, wobei der Takteingang (T) des ersten Rückwärtszählers (36) mit einem Taktgenerator (30) verbunden ist, daß ein invertierender Ausgang ($\overline{Q}$) des ersten Rückwärtszählers (36) mit einem Set-Eingang (S) des zweiten RS-Flip-Flops (38) verknüpft ist, dessen nichtinvertierender Ausgang (Q) mit einem Freigabeeingang (F) des zweiten Rückwärtszählers (40) und ein invertierender Ausgang ($\overline{Q}$) des zweiten Flip-Flops (38) mit einem Eingang (L) des zweiten Rückwärtszählers (40), der die Voreinstellung des zweiten Rückwärtszählers (40) freigibt, verknüpft sind, wobei ein Takteingang (T) des zweiten Rückwärtszählers (40) mit dem Taktgenerator (30) verbunden ist, daß ein invertierender Ausgang ($\overline{Q}$) des zweiten Rückwärtszählers (40) jeweils mit einem Reset-Eingang (R) der beiden RS-Flip-Flops (34, 38) verknüpft ist, daß die Taktsignale des Taktgenerators (30) einem ersten Eingang des UND-Gatters (42) zugeführt sind, dessen zweiter Eingang mit dem nichtinvertierenden Ausgang (Q) des zweiten RS-Flip-Flops (38) verknüpft ist, wobei am Ausgang des UND-Gatters (42) eine verzögerte Impulskette für ein aufkommutierendes Ventil (T6) ansteht.

7. Schaltungsanordnung nach Anspruch 6,**dadurch gekennzeichnet,** daß als erster bzw. zweiter Rückwärtszähler (36 bzw. 40) jeweils ein programmierbarer Rückwärtszähler vorgesehen ist.

8. Schaltungsanordnung nach Anspruch 5,**dadurch gekennzeichnet,** daß die Widerstandsklemmen des Shunt-Widerstandes (10) mit einem Effektivwertumsetzer (44) verknüpft sind, dessen Ausgang mit einem Kennliniengeber (46) verbunden ist, und daß der Ausgang des Kennliniengebers (46) mit den Voreinstellungseingängen ($E_i$ bis $E_n$) des ersten programmierbaren Rückwärtszählers (36) verknüpft ist.

9. Schaltungsanordnung nach Anspruch 8, **dadurch gekennzeichnet,** daß als Kennliniengeber (46) ein programmierbarer Speicher vorgesehen ist.

87 P 8552

FIG 1

FIG 2

87 P 8552

FIG 3

32

T4  T5  T6  T1  T2  T3

$u_U$

$u_d/2$

0

$\pi/2$    $\pi$    $3\pi/2$    $2/\pi$    $\omega t$

$\Delta\alpha$

FIG 4

$u_V$

$\Delta\alpha$

$u_d/2$

0

$\omega t$

FIG 5

$u_W$

$u_d/2$

0

$\omega t$

FIG 6

87 P 8552

FIG 7

FIG 8

FIG 9

FIG 10

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| D,A | DE-C-3 228 815  (SIEMENS)<br>* Zusammenfassung *<br>--- | 1 | G 01 R  31/34 |
| A | DE-A-2 907 595  (FUJI)<br>* Seite 1 *<br>--- | 1 | |
| A | EP-A-0 101 773  (TELEMECANIQUE)<br>----- | | |

|  |  |
|---|---|
| | RECHERCHIERTE SACHGEBIETE (Int. Cl.4) |
| | G 01 R |

Der vorliegende Recherchenbericht wurde für alle Patentansprüche erstellt

| Recherchenort | Abschlußdatum der Recherche | Prüfer |
|---|---|---|
| DEN HAAG | 09-09-1988 | HOORNAERT W. |

EPO FORM 1503 03.82 (P0403)

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus andern Gründen angeführtes Dokument
........................................................................
& : Mitglied der gleichen Patentfamilie, übereinstimmendes
    Dokument